(19) Europäisches Patentamt

European Patent Office

Office européen des brevets

(11) Veröffentlichungsnummer: **0 226 100**
**A1**

(12) **EUROPÄISCHE PATENTANMELDUNG**

(21) Anmeldenummer: 86116562.9

(22) Anmeldetag: 28.11.86

(51) Int. Cl.⁴ **H01L 27/14 , H04N 1/028**

(30) Priorität: 13.12.85 DE 3544121

(43) Veröffentlichungstag der Anmeldung:
24.06.87 Patentblatt 87/26

(84) Benannte Vertragsstaaten:
**DE FR GB NL**

(71) Anmelder: **Heimann GMBH**
**Weher Köppel 6**
**D-6200 Wiesbaden 1(DE)**

(72) Erfinder: **Traupe, Ulrich, Dipl.-Phys.**
**Eltviller Strasse 6**
**D-6200 Wiesbaden(DE)**
Erfinder: **Dennhoven, Manfred, Dipl.-Ing.**
**Kastanienring 13**
**D-5421 Osterspai(DE)**

(74) Vertreter: **Mehl, Ernst, Dipl.-Ing. et al**
**Postfach 22 01 76**
**D-8000 München 22(DE)**

(54) **Kontaktbildsensorzeile.**

(57) Die Erfindung betrifft eine Kontaktbildsensorzeile zum Lesen einer optischen Information mit einer Reihe von lichtelektrischen Sensoren (14) und einer nachgeschalteten Signalaufbereitungsschaltung. Sensoren (15) und Signalaufbereitungsschaltung bilden zusammen eine integrierte Schaltung und sind als Baustein (14) ausgebildet.

FIG 3

EP 0 226 100 A1

## Kontaktbildsensorzeile

Die Erfindung betrifft eine Kontaktbildsensorzeile zum Lesen einer optischen Information mit einer Reihe von lichtelektrischen Sensoren und einer nachgeschalteten Signalaufbereitungsschaltung.

Kontaktbildsensorzeilen ermöglichen das Lesen einer optischen Information eines Textes oder einer Graphik, das Wandeln in eine analoge elektrische Information, die anschließende Wandlung in eine digitale elektrische Information und damit das Sortieren und Speichern der Information. Die digital geordnete und gespeicherte Information kann dann in bekannter Weise für alle Formen der Bildverarbeitung und Bildwiedergabe (z.B. Fernkopierer, Bildschirmwiedergabe) nutzbar gemacht werden.

Bisher wurde dieses Problem durch Zeilensensoren mit Vorschub senkrecht zur Zeilenachse gemäß den folgenden Funktionsprinzipien gelöst:

a) durch Abbildung einer Vorlage mit einer Verkleinerungsoptik auf CCD-Zeilen mit einer Länge von z.B. 22,5 mm. Nachteile sind dabei die geringe Schärfentiefe des Abbildungsstrahlenganges, dadurch extreme Justieranforderungen an das Gerät und hoher Raumbedarf für den Strahlengang.

b) durch 1:1-Abbildung mittels Grin (gradient index)-Faseroptiken auf eine Anordnung von CCD-Zeilen mit jeweils etwa 6 cm Länge. Dabei ergeben sich folgende Nachteile: Die CCD's müssen mit möglichst großer Länge und damit großer Fläche hergestellt werden, um die Vorteile des CCD-Prinzips nutzen zu können. Durch das Schieben der elektrischen Ladungen in den CCD's über Distanzen von 6 cm entstehen jedoch hohe Ladungsverluste. Außerdem können CCD-Chips mit einer derart großen Fläche (z.B. 65 $\times$ 5 mm$^2$ = 325 mm$^2$) nicht in absehbarer Zeit mit genügend hoher Ausbeute, d.h. zu vertretbaren Preisen hergestellt werden, zumal es keine Möglichkeit der Ausbeuteverbesserung durch Einbau von Redundanzen gibt.

c) durch 1:1-Abbildung mittels Grinfaseroptiken auf Sensorzeilen aus einem Photoleitermaterial, z.B. a-Si:H. Die bisher verwendeten Sensorzeilen bestehen aus einer linearen Anordnung von Photoleiterzellen z.B. auf der Basis von a-Si:H, mit 8, 12 oder 16 Bildpunkten/mm und einer Anordnung von Auslese-und Signalaufbereitungselementen. Die Auslese-und Signalaufbereitungselemente sind in monokristalliner Technik ausgeführt. Die Verbindung zwischen den Sensoren und den Auslese-und Signalaufbereitungselementen erfolgt durch Drähte und Leiterbahnen.

Für die Ansteuerung der einzelnen Sensoren und die Signalaufbereitung werden die beiden folgenden Prinzipien angewandt:

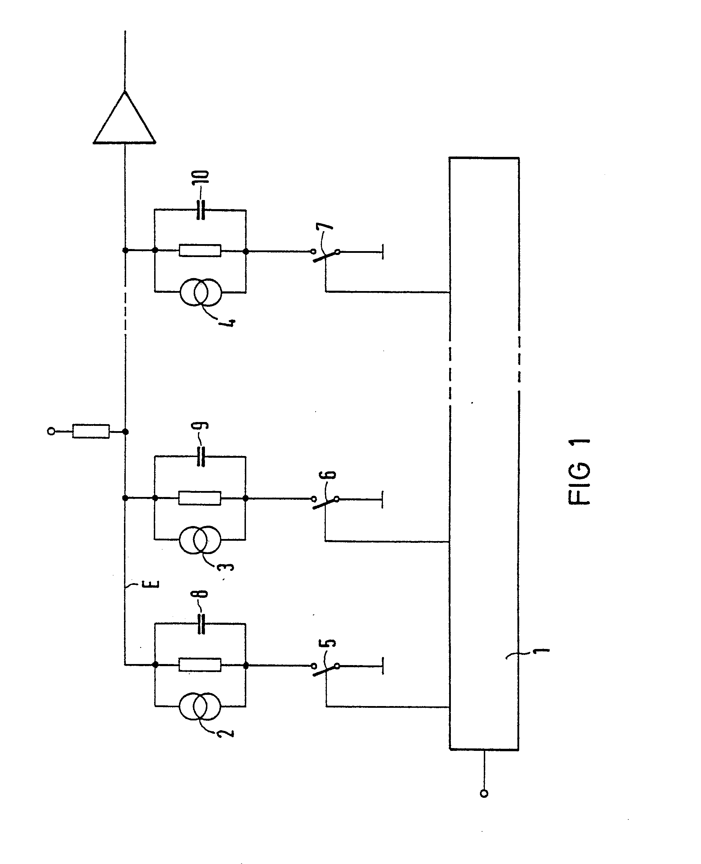

Auslesen nach dem Vidiconprinzip (siehe Figur 1).

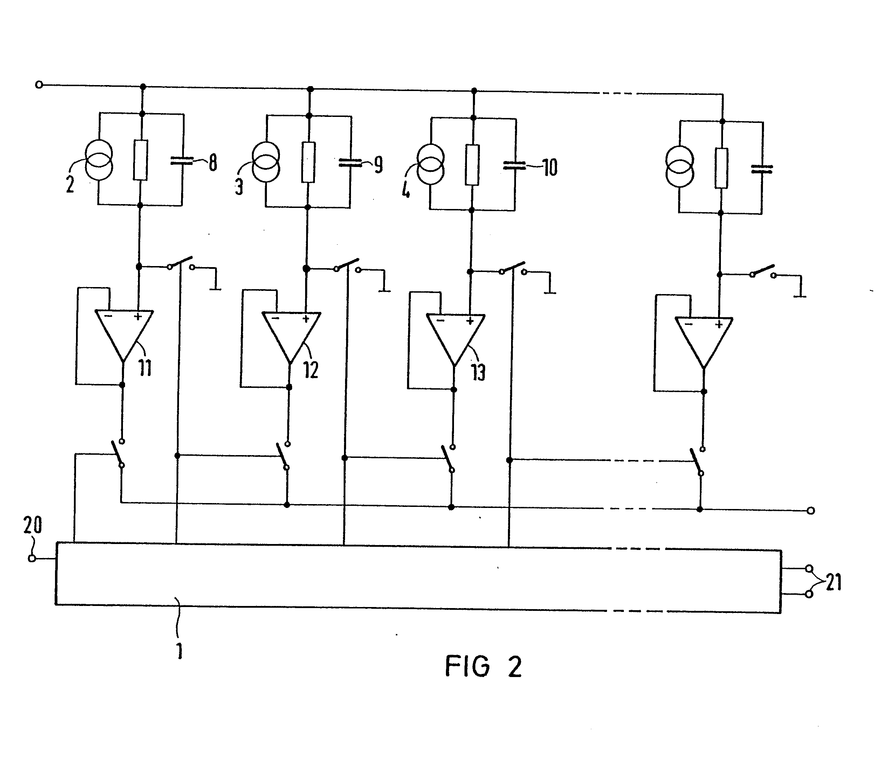

Messung der Spannung an der lichtempfindlichen Zelle (siehe Figur 2).

Bei beiden Prinzipien wird mit Hilfe eines Schieberegisters 1 seriell jeder einzelne Sensor 2, 3, 4 angesteuert.

Ein einzelner, einem Bildpunkt zugeordneter Sensor stellt eine Stromquelle mit Parallelkapazität dar. Bei der Anordnung mit der Auslesung nach dem Vidiconprinzip (Fig. 1) ist eine Elektrode E allen lichtempfindlichen Sensoren 2, 3, 4 gemeinsam. Durch das Schließen eines Schalters 5, 6, 7 nach einer Integrationszeit wird der entsprechende Sensor 2, 3, 4 in den Ausgangszustand zurückgesetzt. Der Strom, der in der gemeinsamen Elektrode E fließt, ist ein Maß für die vom entsprechenden Sensor absorbierte Lichtmenge. Danach beginnt durch Öffnen des Schalters 5, 6, 7 die nächste Integrationsphase des Sensors 2, 3, 4. Durch die Parallelschaltung aller Sensoren 2, 3, 4 wegen der gemeinsamen Elektrode E ist dem jeweils ausgelesenen Sensor 2, 3, 4 eine große Kapazität 8, 9, 10 parallel zugeordnet. Es erfolgt eine kapazitive Signalteilung, die eine sehr hohe Nachverstärkung erfordert. Hierdurch wird ein schlechtes Signal-Rausch-Verhältnis erzielt.

Günstiger sind die Verhältnisse bei dem Prinzip der Messung der Spannung an den einzelnen lichtempfindlichen Sensoren 2, 3, 4 (analoge Signalaufbereitung). Mit Hilfe des Schieberegisters 1 wird gemäß Figur 2 der Entladezustand eines Sensors 2, 3, 4 nach der Integrationszeit an den gemeinsamen Signalausgang von Verstärkern 11, 12, 13, von denen für jeden Sensor 2, 3, 4 (Bildpunkt) jeweils einer vorhanden ist, weitergegeben. Das Schieberegister 1 ist durch Taktimpulse am Eingang 20 getaktet und besitzt einen Signalausgang 21. Sobald der Verstärker 11, 12, 13 des nächsten lichtempfindlichen Sensors 2, 3, 4 an den Ausgang angeschaltet wird, erfolgt die Rücksetzung des vorhergehenden Sensors in den Ausgangszustand und es beginnt eine neue Integrationsphase. Während dieser Zeit ändert sich die Spannung entsprechend

$$U(t) = U_o - \frac{i \cdot t}{C}$$

t : Integrationszeit

i : Strom im Sensor (proportional zur Beleuchtungsstärke)

C : Kapazität des Sensors plus der sonstigen Komponenten wie Verbindungsleitungen und Eingangskapazität des Verstärkers (Kapazitäten 8, 9, 10)

$U_o$: Anfangsspannung.

Die Größe des Signalhubs ist neben der Beleuchtungsstärke und der Integrationszeit in starkem Maße von der Kapazität C abhängig. Wie aus der obigen Gleichung ersichtlich ist, wird der Signalhub mit geringerer Kapazität bei sonst unveränderten Parametern größer. Ein Ziel bei der Entwicklung einer Sensorzeile muß also die Minimierung der den einzelnen Sensoren parallel geschalteten Zusatzkapazitäten sein, die durch Leiterbahnen, Kontaktflächen, Eingang zur Signalauswertung, u.s.w. verursacht werden.

Aufgabe der Erfindung ist es demgemäß, diese zusätzlichen Kapazitäten bei einer Kontaktbildsensorzeile der eingangs genannten Art zu minimieren.

Diese Aufgabe ist erfindungsgemäß dadurch gelöst, daß jedem Sensor ein individueller Verstärker nachgeschaltet ist und daß Sensoren und Verstärker zusammen eine integrierte Schaltung bilden und als Baustein ausgebildet sind, wobei mehrere Bausteine in Reihe liegen. Auf einem solchen Signalaufbereitungs/Ansteuerbaustein können z. B. 128 Bildpunkte linear angeordnet werden. Die schädlichen Zusatzkapazitäten sind dabei auf ein Minimum reduziert.

Einzelheiten der Erfindung ergeben sich aus den Unteransprüchen.

Die Erfindung ist nachfolgend anhand eines in der Zeichnung dargestellten Ausführungsbeispiels näher erläutert.

Es zeigen:

Fig. 3 eine Kontaktbildsensorzeile nach der Erfindung,

Fig. 4 die Aneinanderreihung mehrerer Kontaktbildsensorzeilen gemäß Fig. 3, und

Fig. 5 eine Variante der Ausführung gemäß Fig. 4.

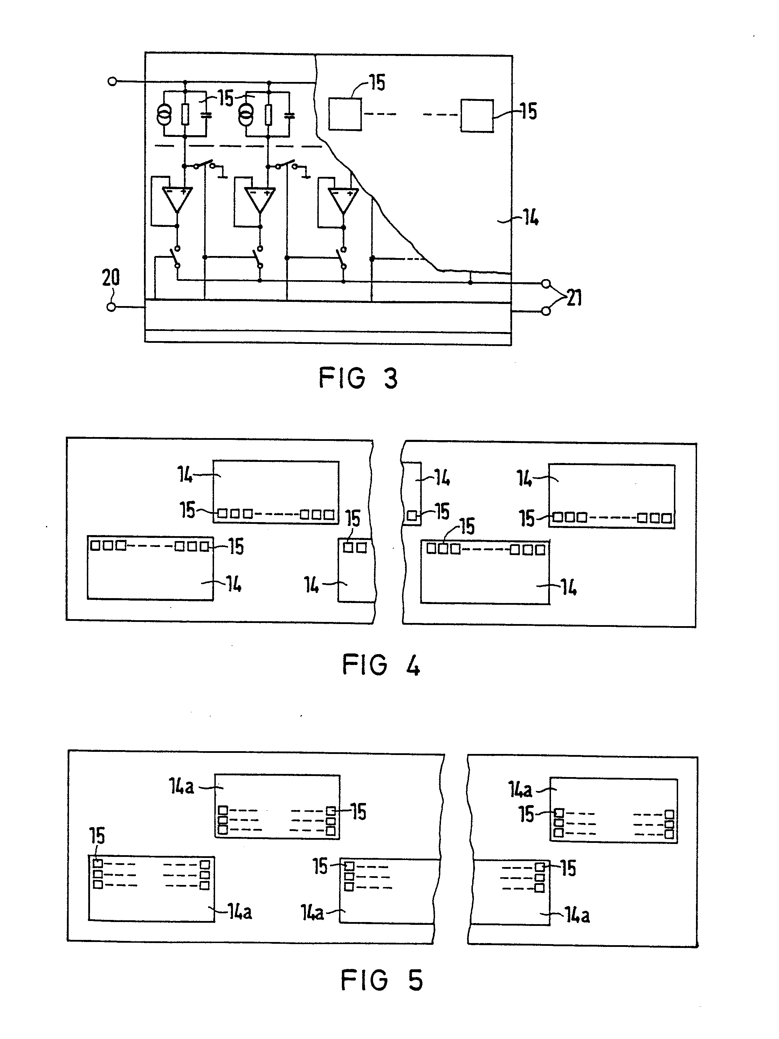

In der Fig. 3 ist ein Baustein 14 dargestellt, der eine Reihe von optischen Sensoren 15, z. B. Fotodioden, Fototransistoren oder Fotokondensatoren, und die zugeordnete Signalaufbereitungsschaltung als integrierte Schaltung enthält. Die zu wandelnde Vorlage wird dabei senkrecht zu der Reihe von Sensoren 15 relativ zum Baustein 14 bewegt.

Durch Aneinanderreihen von Bausteinen 14, von denen einer bei dem Beispiel gemäß Fig. 3 128 Sensoren 15 entsprechend 128 Bildpunkten enthält, kann eine Kontaktbildsensorzeile beliebiger Länge aufgebaut werden, die an das jeweils zu lesende Format für eine Abbildung im Maßstab 1 : 1 angepaßt ist.

Bei der Aneinanderreihung der Bausteine 14 können durch Positionierungsschwierigkeiten an der Stoßgrenze von Baustein zu Baustein Unregelmäßigkeiten in der Bildpunktanordnung auftreten. Diese Schwierigkeiten sind durch die Ausführung gemäß Fig. 4 überwunden. Bei dieser Ausführung sind mehrere Bausteine 14 versetzt aneinander angereiht, so daß sich zwei Zeilen mit einem Abstand von z. B. 330 μm ergeben. Die ausgelesenen Signale werden dabei zwischengespeichert und geordnet.

Statt einer Sensorreihe pro Baustein 14 können z. B. auch drei Sensorreihen pro Baustein 14a gemäß Fig. 5 vorgesehen werden. Der Abstand der Sensorreihen richtet sich ausschließlich nach den Bedingungen des optischen Abbildungssystems. Mit einer Anordnung gemäß Fig. 5 ist es möglich, durch zeilenweise farbige Abbildung oder Filterung eine Vorlage farbig zu lesen und zu verarbeiten. Die Anordnung muß nicht notwendigerweise drei Zeilen pro Baustein 14a besitzen. Es sind auch andere Zeilenzahlen und andere als zeilenförmige Farbkodierungen möglich. Wesentlich ist, daß bei Verwendung von mehreren Zeilen eine Farbverarbeitung mit höherer Bildpunktauflösung als bei Verwendung nur einer Sensorzeile möglich ist und daß durch die Parallelauswertung der Farbauszüge keine Verlängerung der Lesezeit gegenüber Schwarz-Weiß-Auslesungen erforderlich ist.

Die Anordnung gemäß Fig. 5 kann ohne Farbkodierung auch zum beschleunigten Schwarz-Weiß-Auslesen einer Information benutzt werden, damit bei dieser Anordnung bei gleicher Integrationszeit pro Zeile die Lesezeit pro Zeile um den Faktor der zusätzlich vorhandenen Sensorzeilen verkürzt wird. Für diese Anwendung ist allerdings ein diskontinuierlicher Zeilenvorschub notwendig.

## Ansprüche

1. Kontaktbildsensorzeile zum Lesen einer optischen Information mit einer Reihe von lichtelektrischen Sensoren (15) und einer nachgeschalteten Signalaufbereitungsschaltung (Fig. 1, 2), **dadurch gekennzeichnet**, daß jedem Sensor (15) ein individueller Verstärker (11, 12, 13) nachgeschaltet ist und daß Sensoren (15) und Verstärker (11, 12, 13) zusammen eine integrierte Schaltung bilden und als Baustein (14) ausgebildet sind, wobei die Sensorzeile aus mehreren in Reihe liegenden Bausteinen (14) aufgebaut ist.

2. Kontaktbildsensorzeile nach Anspruch 1, **dadurch gekennzeichnet**, daß mehrere Bausteine (14) versetzt aneinander angereiht sind.

3. Kontaktbildsensorzeile nach Anspruch 1 oder 2, **dadurch gekennzeichnet**, daß jeder Baustein (14a) mehrere parallele Sensorreihen aufweist.

FIG 1

FIG 2

0 226 100

0 226 100

FIG 3

FIG 4

FIG 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | GB-A-2 044 996 (NIPPON HOSO KYOKAI) <br> * Zusammenfassung; Seite 2, Zeilen 3-39; Figuren 1a-1c * | 1 | H 01 L 27/14 <br> H 04 N 1/028 |
| Y | | 2,3 | |
| | --- | | |
| Y | DE-A-3 432 185 (K.K. TOSHIBA) <br> * Zusammenfassung; Figur 5 * | 2 | |
| | --- | | |
| Y | US-A-4 303 936 (SHAW) <br> * Spalte 4, Zeilen 12-15; Figur 2 * | 3 | |
| | --- | | |
| A | EP-A-0 028 960 (THOMSON-CSF) <br> * Zusammenfassung; Seite 5, Zeilen 14-23; Figur 2 * | 1 | RECHERCHIERTE SACHGEBIETE (Int. Cl.4) |
| | --- | | H 01 L <br> H 04 N |
| A | FR-A-2 302 594 (R.T.C.) <br> * Seite 1, Zeilen 7-14; Seite 7, Zeile 33 - Seite 8, Zeile 17; Figur 4 * | 1 | |
| | ----- | | |

Der vorliegende Recherchenbericht wurde für alle Patentansprüche erstellt.

| Recherchenort | Abschlußdatum der Recherche | Prüfer |
|---|---|---|
| DEN HAAG | 04-03-1987 | BAILLET B.J.R. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument